# EUROPEAN PATENT SPECIFICATION

(11) **EP 2 670 050 B1**
(45) Date of publication and mention of the grant of the patent: **01.03.2017**
(21) Application number: 13164872.7
(22) Date of filing: 23.04.2013
(51) Int. Cl.: H03G 3/30, H03G 9/00

(54) **Method and apparatus for processing audio signal**
Verfahren und Vorrichtung zur Tonsignalverarbeitung
Procédé et appareil de traitement de signal audio

(30) Priority: 29.05.2012 KR 20120056871
(43) Date of publication of application: 04.12.2013
(73) Proprietor: Samsung Electronics Co., Ltd, Gyeonggi-do 443-742 (KR)
(72) Inventor: Kudryavtsev, Vadim, 443-742 Gyeonggi-do (KR); Kim, Jaehyun, 443-742 Gyeonggi-do (KR); Choi, Chulmin, 443-742 Gyeonggi-do (KR)
(74) Representative: Birchenough, Lewis

(56) References cited:
- WO-A1-2011/100802
- US-A1- 2007 270 988
- US-A1- 2009 038 468
- DUXBURY C ET AL: "SEPARATION OF TRANSIENT INFORMATION IN MUSICAL AUDIO USING MULTIRESOLUTION ANALYSIS TECHNIQUES", PROCEEDINGS OF COST G-6 CONFERENCE ON DIGITAL AUDIO EFFECTS, XX, XX, 6 December 2001 (2001-12-06), pages 1-4, XP002373302,
- GILLET O ET AL: "Transcription and Separation of Drum Signals From Polyphonic Music", IEEE TRANSACTIONS ON AUDIO, SPEECH AND LANGUAGE PROCESSING, IEEE SERVICE CENTER, NEW YORK, NY, USA, vol. 16, no. 3, 1 March 2008 (2008-03-01), pages 529-540, XP011329048, ISSN: 1558-7916, DOI: 10.1109/TASL.2007.914120

## Description

### TECHNICAL FIELD

The present disclosure relates to a method and an apparatus for processing an audio signal, and more particularly, to a method of processing an audio signal which adjusts a gain by separating the audio signal into a harmonic signal and a percussion signal, and an apparatus thereof.

### BACKGROUND

A dynamic range controller (DRC) dynamically adjusts magnitude of an output according to magnitude of an input, and refers to an audio gain controller for increasing an output of a speaker.

In general, audio gain control according to the related art is achieved using one DRC.

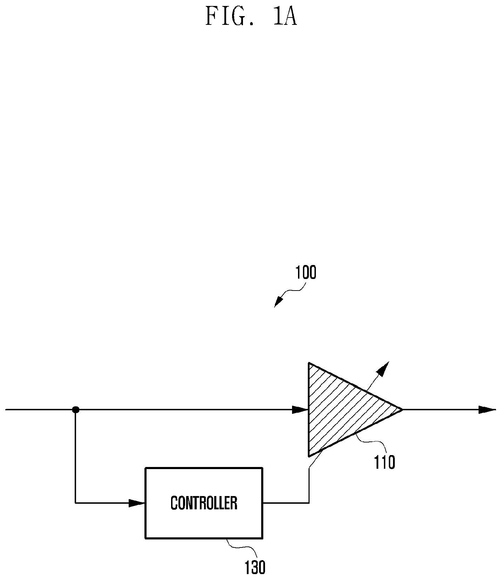

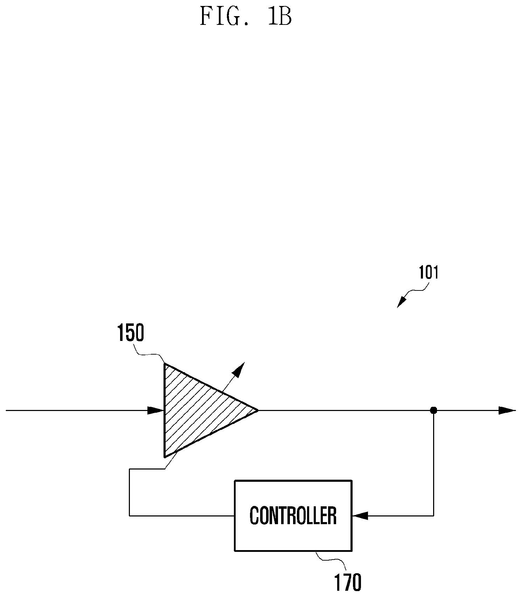

FIG. 1A illustrates a DRC 100 having a forward structure, which includes a controller 130 controlling a gain and an amplifier 110. FIG. 1B illustrates a DRC 101 having a feedback structure, which includes a controller 170 controlling a gain and an amplifier 150. The DRC 101 having the feedback structure analyzes an output signal to dynamically adjust the gain. A gain controller of the audio gain controller according to the related art determines a maximum value or a Root Mean Square (RMS) of input/output signal level, and calculates a required gain using a gain function. An input signal is multiplied by a gain, and accordingly magnitude of an output signal is controlled.

Meanwhile, recent pop music generally includes a percussion signal output from a percussion instrument. The percussion signal has predetermined energy in a time domain and is intermittently generated as compared with a continuously input harmonic signal. The percussion signal has a spike format in a time spectrum. That is, since the percussion signal is interposed between continuous harmonic signals, the percussion signal can be bounced in the middle of a time spectrum. Such a characteristic of the percussion signal causes a problem when an output level is maximized. In order to prevent the audio signal from being distorted, a maximum value of the audio signal can be amplified to a predetermined level. An amplifiable level is limited due to a percussion signal having the spike format. That is, although an average of the output level is extremely less than a maximum value, it is impossible to increase a gain longer to maintain a format of the percussion signal.

The document: Proceedings of the COST G-6 Conference on Digital Audio Effects (DAFX-01), Limerick, Ireland, December 6-8, 2001, SEPARATION OF TRANSIENT INFORMATION IN MUSICAL AUDIO USING MULTIRESOLUTION ANALYSIS TECHNIQUES, Chris Duxbury, Mike Davies, Mark Sandler, shows a percussive post-processing algorithm.

### SUMMARY

The invention is defined by the appended claims.

To address the above-discussed deficiencies, a method and an apparatus for processing an audio signal improve controlling a gain and adopt a reproducing volume level to a current environment by separating the audio signal into a harmonic signal and a percussion signal to adjust a gain.

The present disclosure further provides an apparatus and a method for processing an audio signal having a high output level without non-linear distortion by separately processing the audio signal into a harmonic signal and a percussion signal.

Objects of the embodiments may not be limited to the above. Other objects that are not described may be clearly comprehended to those of skill in the art to which the embodiment pertains through the following description. It should be understood that objects and advantages of the present disclosure may be realized by means described in claims and a combination thereof.

In accordance with embodiments of the present disclosure, a method of processing an audio signal includes: separating the audio signal into a first harmonic signal and a first percussion signal; adjusting gains of the first harmonic signal and the first percussion signal to generate a second harmonic signal and a second percussion signal; and adding the second harmonic signal and the second percussion signal.

In accordance with embodiments of the present disclosure, an apparatus for processing an audio signal includes: a harmonic/percussion separator separating the audio signal into a first harmonic signal and a first percussion signal; a first DRC adjusting a gain of the harmonic signal to generate a second harmonic signal; a second DRC adjusting a gain of the percussion signal to generate a second percussion signal; and an adder adding the first harmonic signal and the second percussion signal.

Before undertaking the DETAILED DESCRIPTION below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, such a device may be implemented in hardware, firmware or software, or some combination of at least two of the same. It should be noted that the functionality associated with any particular controller may be centralized or distributed, whether locally or remotely. Definitions for certain words and phrases are provided throughout this patent document, those of ordinary skill in the art should understand that in many, if not most instances, such definitions apply to prior, as well as future uses of such defined words and phrases.

### BRIEF DESCRIPTION OF THE DRAWINGS

For a more complete understanding of the present disclosure and its advantages, reference is now made to the following description taken in conjunction with the accompanying drawings, in which like reference numerals represent like parts:
FIGS. 1A and 1B illustrate a configuration of an audio gain controller according to the present disclosure;
FIG. 2 illustrates an apparatus for processing an audio signal according to embodiments of the present disclosure;
FIG. 3 illustrates a harmonic/percussion separator of the apparatus for processing an audio signal of FIG. 2 according to an embodiments of the present disclosure;
FIGS. 4A to 4E illustrate signal processing results by an apparatus for processing an audio signal according to embodiments of the present disclosure;
FIGS. 5A and 5B illustrate an operation principle of a harmonic spectrogram generator of the apparatus for processing an audio signal according to embodiments of the present disclosure;
FIGS. 6A and 6B illustrate an operation principle of a percussion spectrogram generator of the apparatus for processing an audio signal according to embodiments of the present disclosure;
FIG. 7 illustrates a method for processing an audio signal according to embodiments of the present disclosure;
FIG. 8 illustrates a procedure of separating an audio signal into a harmonic signal and a percussion signal during the method for processing an audio signal according to embodiments of the present disclosure;
FIG. 9 illustrates a procedure of acquiring a harmonic spectrogram using a spectrogram during the method for processing an audio signal according to embodiments of the present disclosure; and
FIG. 10 illustrates a procedure of acquiring a percussion spectrogram using the spectrogram during the method for processing an audio signal according to embodiments of the present disclosure.

### DETAILED DESCRIPTION

FIGURES 1a through 10, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged audio signal processing device. Exemplary embodiments of the present disclosure are described with reference to the accompanying drawings in detail. The same reference numbers are used throughout the drawings to refer to the same or like parts. Detailed descriptions of well-known functions and structures incorporated herein may be omitted to avoid confusing the subject matter of the present disclosure.

In the present disclosure, separated harmonic signal and percussion signal are defined as follows. First, the percussion signal refers to an audio signal by an instrument called percussion or a percussion instrument outputting a sound by beating. Since the percussion signal is generally used to keep time with music, the percussion signal has energy distribution in which a spike format is intermittently generated in a time spectrum. The harmonic signal refers to a periodic component composed of at least two sounds. Energy of the harmonic signal has a predetermined value according to a time as compared with the percussion signal and represents an energy distribution of a spike format in a frequency spectrum.

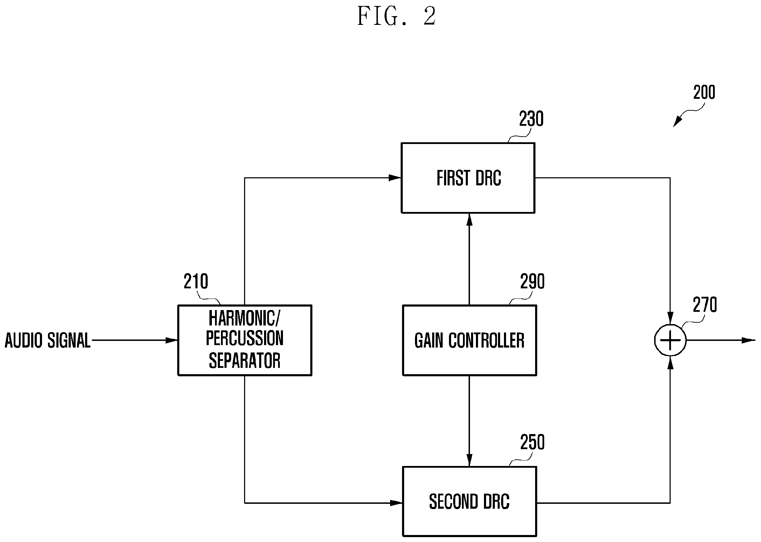

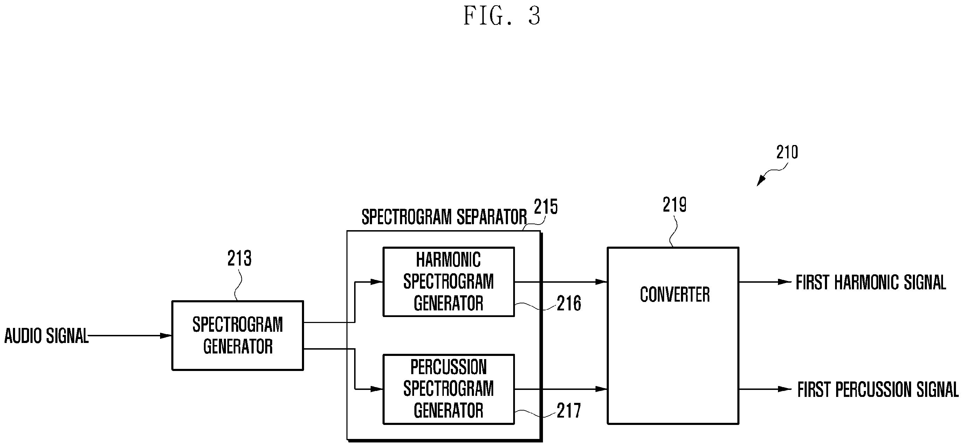

Hereinafter, the apparatus for processing an audio signal according to embodiments of the present disclosure will be described with reference to FIGS. 2 and 3.

FIG. 2 illustrates an apparatus 200 for processing an audio signal according to embodiments of the present disclosure. FIG. 3 illustrates a harmonic/percussion separator 210 of the apparatus 200 for processing an audio signal of FIG. 2 according to embodiments of the present disclosure.

Referring to FIG. 2, the apparatus 200 for processing an audio signal according to embodiments of the present disclosure includes a harmonic/percussion separator 210, a first DRC 230, a second DRC 250, and an adder 270, and in certain embodiments further includes a separate gain controller 290.

The harmonic/percussion separator 210 separates an audio signal into a harmonic signal and a first percussion signal. The harmonic/percussion separator 210 will be described in detail with reference to FIG. 3. The harmonic/percussion separator 210 includes a spectrogram generator 213, a spectrogram separator 215, and a converter 219. The spectrogram separator 215 includes a harmonic spectrogram generator 216 and a percussion spectrogram generator 217. The spectrogram generator 213 converts the audio signal into a time frequency domain to generate a spectrogram of the audio signal. The spectrogram illustrates intensity of a frequency spectrum component of the audio signal as a density of a figure, in which frequency is on a vertical axis and time is on a horizontal axis. The spectrogram generator 213 performs a Discrete Fourier transform (DFT) or a Fast Fourier transform (FFT) on an input audio signal according to a time to acquire a frequency spectrum of the audio signal according to the time. As another embodiment, the spectrogram generator 213 uses a filter bank in order to acquire a frequency component. The filter bank is a filter group which divides a frequency band of the audio signal by a plurality of band pass filters. The spectrogram generator 213 extracts frequency components of respective bands by passing the audio signal through the filter bank, and adds the extracted frequency components to generate a frequency spectrum according to a time as a spectrogram.

The spectrogram separator 215 creates the harmonic spectrogram and the spectrogram using the spectrogram of the audio signal from the spectrogram generator 213. In detail, the harmonic spectrogram generator 216 generates the harmonic spectrogram using the spectrogram, and the percussion spectrogram generator 217 generates the percussion spectrogram using the spectrogram.

The harmonic spectrogram generator 216 slices the spectrogram received from the spectrogram generator 213 for each preset frequency to generate at least one frequency frame, and performs median filtering with respect to the respective frequency frames. The median filter has a characteristic which substitutes a median value in a window centering around one point for a value of the one point. If the harmonic spectrogram generator 216 performs median filtering with respect to a frequency frame being an audio signal of a specific frequency band according to a time, a percussion component spiked in a time axis spectrum is suppressed. The harmonic spectrogram generator 216 combines at least one frequency frame in which a percussion component is suppressed by the filtering with each other to generate the harmonic spectrogram.

The percussion spectrogram generator 217 slices the spectrogram received from the spectrogram generator 213 for each preset time to generate at least one time frame, and performs median filtering with respect to the respective time frames. If the percussion spectrogram generator 217 performs median filtering with respect to a time frame being a frequency spectrum at a specific time, a harmonic component spiked in the frequency spectrum is suppressed. The percussion spectrogram generator 217 combines at least one time frame in which a harmonic component is suppressed by the filtering with each other to generate the percussion spectrogram.

The converter 219 converts the harmonic spectrogram and the percussion spectrogram output from the spectrogram separator 215 into a first harmonic signal and a first percussion signal which are signals in a time domain, respectively.

The first harmonic signal and the first percussion signal separated by the harmonic/percussion separator 210 are input to the first DRC 230 and the second DRC 250, respectively. The first DRC 230 adjusts a gain of the first harmonic signal to generate a second harmonic signal. The first DRC 230 adjusts the gain of the first harmonic signal so that the second harmonic signal does not exceed a first threshold. The second DRC 250 adjusts the gain of the first percussion signal to generate a second percussion signal. The second DRC 250 adjusts the gain of the first percussion signal so that the second percussion signal does not exceed a second threshold.

The first threshold and the second threshold can be 0dB for maximizing an output level, and can have different values. The first DRC 230 and the second DRC 250 have a DRC structure, the same structure, or different structures. That is, the first DRC 230 and the second DRC 250 are independent of each other. When the first DRC 230 and the second DRC 250 have the same structure, the first DRC 230 and the second DRC 250 can have different parameters (time constants, gains) as necessary.

In certain embodiments, the apparatus 200 for processing an audio signal according to the present disclosure further includes the gain controller 290 as a separate module. The gain controller 290 simultaneously controls gains adjusted by respective DRCS 230, 250 which are independently operated. That is, the gain controller 290 controls both of the gains of the first harmonic signal and the first percussion signal so that a difference between the gains of the first harmonic signal and the first percussion signal is less than a preset value. That is, the gain controller 290 simultaneously controls the gains of the first harmonic signal and the first percussion signal in order to prevent mismatch of an extent capable of being recognized between signals as a gain difference of both channels is increased.

That is, a gain control module is included inside the first DRC 230 and the second DRC 250 and independently adjust gains of the DRCs. The gain control module adjusts gains of the second harmonic signal and the second percussion signal so that the second harmonic signal matches with the second percussion signal in consideration of the gain of each DRC at an outside of the DRC in the same scheme as that of the gain controller 290 of FIG. 2. Here, the gain control module individually adjusts parameters such as a time constant as well as gains of respective signals. Upon adjusting the time constant, formats of respective signals can be changed. For example, when increasing the time constant, the signal becomes gentle. When reducing the time constant, the signal changes to a sharp format.

The first DRC 230 and the second DRC 250 adjust gains or time constants of the first harmonic signal and the percussion signal, the adder 270 adds the second harmonic signal and the second percussion signal having the adjusted gains to each other, and outputs the addition result. Using the foregoing scheme, the harmonic signal and the percussion signal are separated from the audio signal, gains of the harmonic signal and the percussion signal are individually adjusted, and the adjusted gains of the harmonic signal and the percussion signal are added to each other, and the addition result is output, so that a total volume of an output signal can be increased without non-linear distortion of some signals.

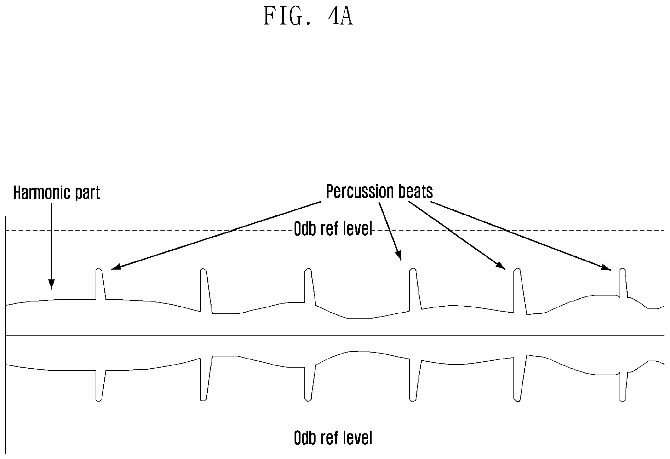

The following is a description of outputs from respective modules in the apparatus for processing an audio signal according to the present disclosure with reference to FIGS. 4A to 4E.

FIGS. 4A to 4E are graphs illustrating signal processing results by an apparatus for processing an audio signal according to the apparatus 200 for processing an audio signal according to embodiments of the present disclosure. In detail, FIG. A is a graph illustrating an audio signal which is input to an apparatus for processing an audio signal. As illustrated in FIG. 4A, the audio signal includes percussion beats (hereinafter referred to as 'percussion signal') having a periodic spike format and a harmonic part (hereinafter referred to as 'harmonic signal') having a relative constant energy along a time axis.

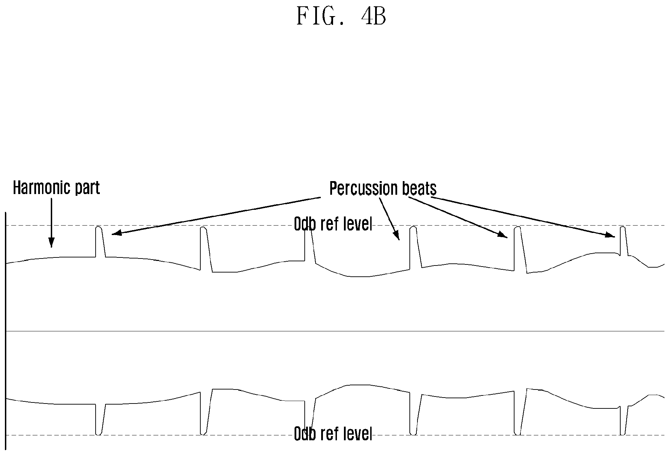

FIG. 4B is a graph of a case where an apparatus for processing an audio signal according to FIG. 1, that is, one DRC adjusts a gain of the audio signal. A format of an audio signal should maintain when an output level of the audio signal is maximized, accordingly, a maximum value of the percussion signal having the spike format should be less than 0dB. If the gain is increased greater than 0dB, the percussion signal is cut or distorted so that clipping or saturation can be caused. Therefore, according, there can be a limitation to amplify an output of a harmonic signal constituting the first half of the audio signal.

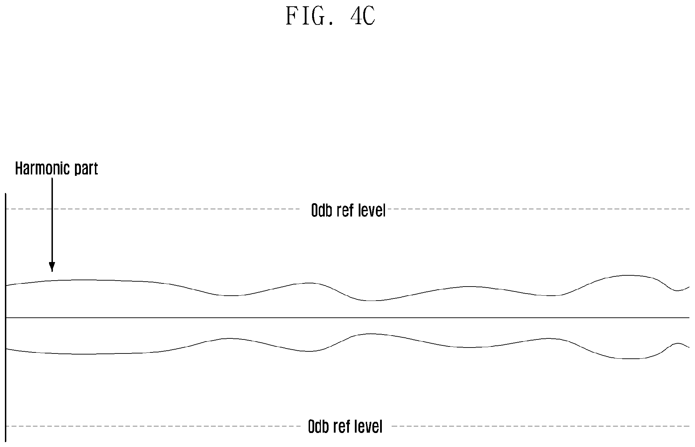

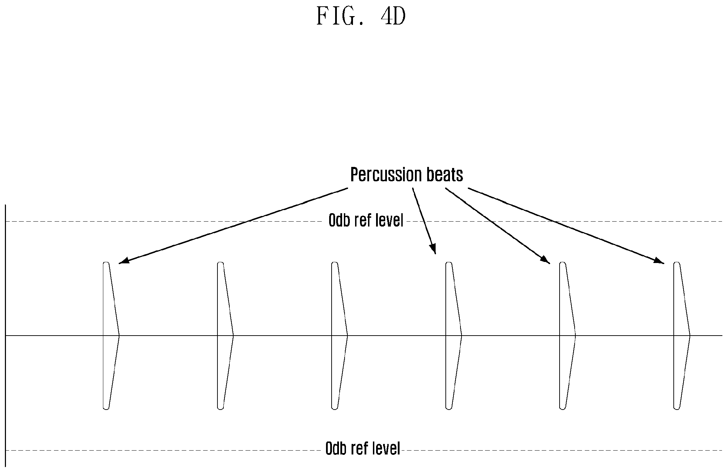

FIGS. 4C and 4D are graphs illustrating respective signals when the apparatus 200 for processing an audio signal according to the present disclosure separates the audio signal into a harmonic signal and a percussion signal. FIG. 4C illustrates only the harmonic signal separated by the harmonic/percussion separator, and the separated harmonic signal is input to the first DRC 230 so that a gain of the harmonic signal is adjusted by the first DRC 230. FIG. 4D illustrates only the percussion signal separated by the harmonic/percussion separator 210, and the separated percussion signal is input to the second DRC 250 so that a gain of the percussion signal is adjusted by the second DRC 250.

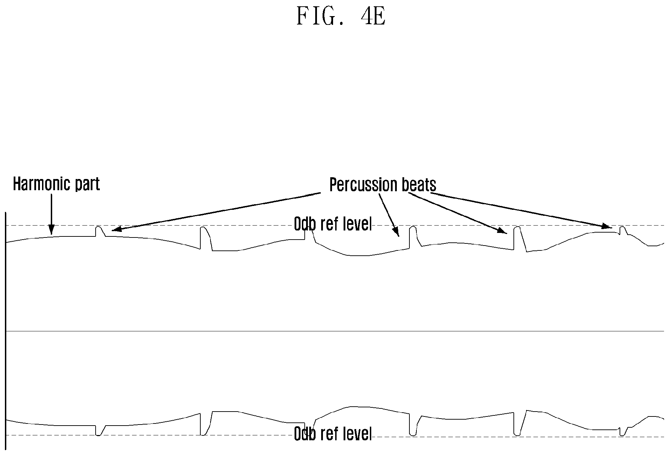

FIG. 4E is a graph illustrating an output signal of the apparatus for processing an audio signal according to the present disclosure. In the apparatus 200 for processing an audio signal according to the present disclosure, the harmonic signal and the percussion signal are input to different DRCs so that gains of the harmonic signal and the percussion signal are individually adjusted. Respective signals in different channels of which gains are adjusted are added by the adder 270 so that the addition result is output. In a characteristic of the percussion signal having the spike format, the gain of the first DRC 230 for adjusting the gain of the harmonic signal can be set to be greater than the gain of the second DRC 250. Referring to FIG. 4E, the percussion signal can be amplified to a maximum output level without distortion, and the harmonic signal is amplified to have a level higher than a level of an output signal of an apparatus for processing an audio signal having one DRC adjust a gain of the audio signal.

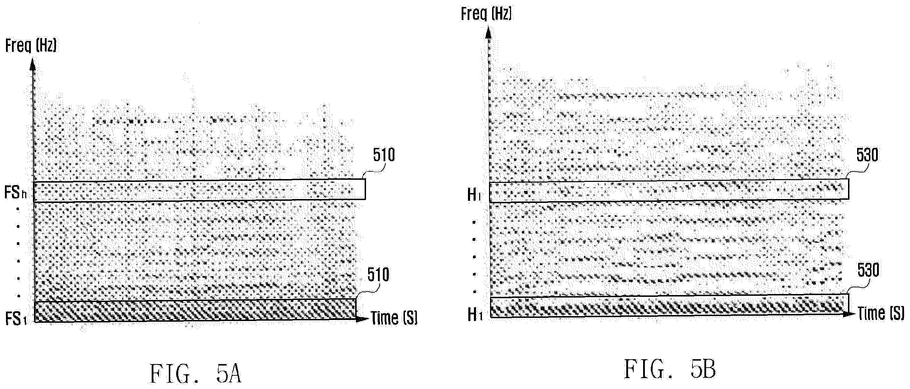

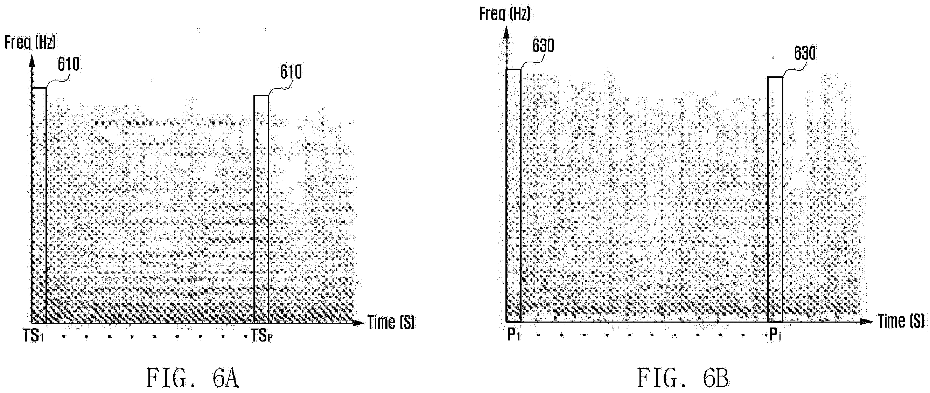

Hereinafter, a method of acquiring a harmonic spectrogram and a percussion spectrogram from a spectrogram of an audio signal will be described with reference to FIGS. 5A, 5B, 6A and 6B.

FIGS. 5A and 5B are graphs illustrating an operation principle of a harmonic spectrogram generator of the apparatus 200 for processing an audio signal according to embodiments of the present disclosure, and FIGS. 6A and 6B are graphs illustrating an operation principle of a percussion spectrogram generator of the apparatus for processing an audio signal according to embodiments of the present disclosure.

FIG. 5A illustrates a spectrogram of an audio signal. A harmonic spectrogram generator 216 generates a harmonic spectrogram using the spectrogram of the audio signal. First, as shown in FIG. 5A, the harmonic spectrogram generator 216 slices the spectrogram for each preset frequency to generate frequency frames FS1, FS2...... FSh 510. The harmonic spectrogram generator 216 performs median filtering with respect to the frequency frames. When performing the median filtering, since a part spiked, that is, relatively bounced in a time spectrum included in the frequency frame is suppressed, the harmonic spectrogram generator 216 generates a frequency frame Hi 530 of FIG. 5B having a suppressed percussion component. The harmonic spectrogram generator 216 combines H1, H2...... Hi 530 with each other to generate a harmonic spectrogram as illustrated in FIG. 5B.

FIG. 6A illustrates a spectrogram of the audio signal. A percussion spectrogram generator 217 generates a percussion spectrogram using the spectrogram of the audio signal. First, as shown in FIG. 6A, the percussion spectrogram generator 217 slices the spectrogram for each preset time to generate time frames TS1, TS2...... TSh 610. The percussion spectrogram generator 217 performs median filtering with respect to the respective time frames. When performing the median filtering, since a spiked part (that is, relatively bounced in a frequency spectrum included in the frequency frame) is suppressed, the percussion spectrogram generator 217 acquires a time frame Pi 630 of FIG. 6B having a suppressed harmonic component. The percussion spectrogram generator 217 combines P1, P2...... Pi 630 with each other to generate a percussion spectrogram as illustrated in FIG. 6B.

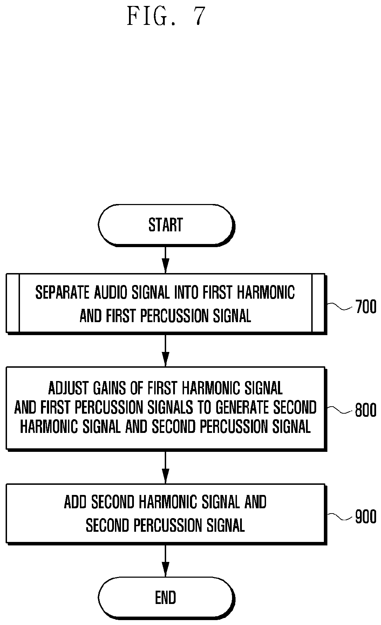

Hereinafter, the method of processing an audio signal according to the embodiment of the present disclosure will be described with reference to FIGS. 7 to 10.

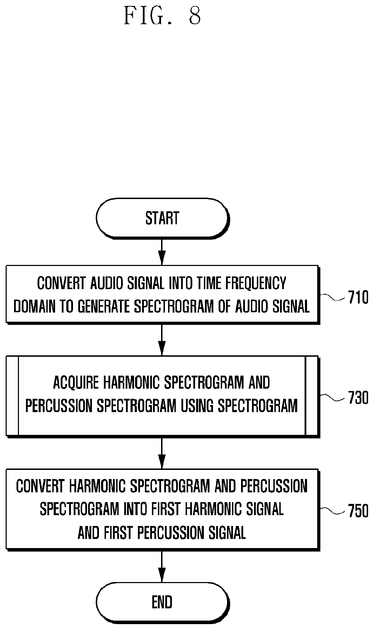

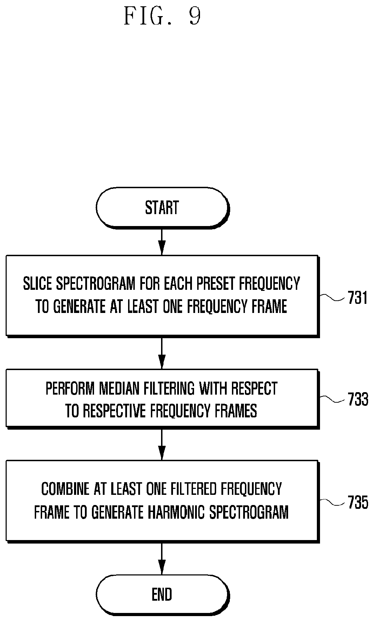

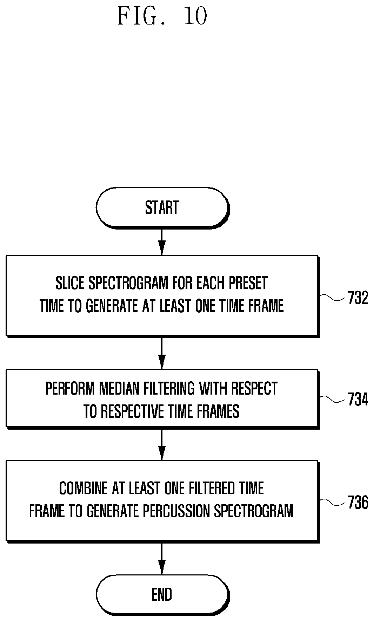

FIG. 7 illustrates a method for processing an audio signal according to embodiments of the present disclosure; FIG. 8 illustrates an example of a procedure of separating an audio signal into a harmonic signal and a percussion signal in detail during the method for processing an audio signal according to embodiments of the present disclosure; FIG. 9 illustrates a procedure of acquiring a harmonic spectrogram using a spectrogram during the method for processing an audio signal according to embodiments of the present disclosure; and FIG. 10 is a flowchart illustrating an example of a procedure of acquiring a percussion spectrogram using the spectrogram during the method for processing an audio signal according to embodiments of the present disclosure.

Referring to FIG. 7, an apparatus 200 for processing an audio signal according to the present disclosure separates an audio signal into a first harmonic signal and a first percussion signal (block 700). A procedure of separating the audio signal into the first harmonic signal and the first percussion signal is as follows.

Referring to FIG. 8, the apparatus 200 for processing an audio signal converts the audio signal into a time frequency domain to generate a spectrogram of the audio signal in order to separate the audio signal (block 710). The spectrogram illustrates intensity of a frequency spectrum component of the audio signal as a density of a figure, in which frequency is on a vertical axis and time is on a horizontal axis.

In order to generate the spectrogram of the audio signal, the apparatus 200 for processing an audio signal performs a DFT or an FFT on an input audio signal according to a time to acquire a frequency spectrum of the audio signal according to the time. In certain embodiments, the apparatus 200 for processing an audio signal uses a filter bank to acquire a frequency component. The filter bank is a filter group that divides a frequency band of the audio signal by a plurality of band pass filters. The apparatus 200 for processing an audio signal extracts frequency components of respective bands by passing the audio signal through the filter bank and adds the extracted frequency components to generate a frequency spectrum according to a time as a spectrogram.

In block 730, the apparatus 200 for processing an audio signal acquires a harmonic spectrogram and a percussion spectrogram using the spectrogram generated in block 710. More particularly, the apparatus 200 for processing an audio signal generates the harmonic spectrogram and the percussion spectrogram using the spectrogram, respectively.

Referring to FIG. 9, in order to generate the harmonic spectrogram, the apparatus 200 for processing an audio signal slices the spectrogram for each preset frequency to generate at least one frequency frame (block 731). The apparatus 200 for processing an audio signal performs median filtering with respect to the respective frequency frames (block 733). The median filter substitutes a median value in a window centering around one point for a value of the one point. When performing the median filtering with respect to a frequency frame being an audio signal of a specific frequency band according to a time, a percussion component spiked in a time axis spectrum is suppressed. The apparatus 200 for processing an audio signal combines at least one frequency frame in which a percussion component is suppressed by the filtering with each other to generate the harmonic spectrogram (block 735).

Referring to FIG. 10, in order to generate the percussion spectrogram, the apparatus 200 for processing an audio signal slices the spectrogram for each preset time to generate at least one time frame (block 732). The apparatus 200 for processing an audio signal performs median filtering with respect to the respective time frames (block 734). When performing median filtering with respect to a time frame being a frequency spectrum at a specific time, a harmonic component spiked in the frequency spectrum is suppressed. Next, the apparatus 200 for processing an audio signal combines at least one time frame in which a harmonic component is suppressed by the filtering with each other to generate the percussion spectrogram (block 736).

In block 750, after acquiring the harmonic spectrogram and the percussion spectrogram from the spectrogram of the audio signal, the apparatus 200 for processing an audio signal converts the harmonic spectrogram and the percussion spectrogram into a first harmonic signal and a first percussion signal, which are signals in a time domain, respectively. The apparatus 200 for processing an audio signal separates the audio signal into the harmonic signal and the percussion signal in steps 710 to 750.

Referring back to FIG. 7, the apparatus 200 for processing an audio signal adjusts gains of the first harmonic signal and the first percussion signals which are separated to generate a second harmonic signal and a second percussion signal (block 800). Although not shown, when generating the second harmonic signal, the apparatus 200 for processing an audio signal adjusts the gain of the first harmonic signal so that the second harmonic signal does not exceed a first threshold. When generating the second percussion signal, the apparatus 200 for processing an audio signal adjusts the gain of the first percussion signal so that the second percussion signal does not exceed a second threshold. The first threshold and the second threshold can be 0dB for maximizing an output level, and can have different values.

The apparatus 200 for processing an audio signal controls both of the gains of the first harmonic signal and the first percussion signal so that a difference between the gains of the first harmonic signal and the first percussion signal is less than a preset value. That is, the apparatus 200 for processing an audio signal simultaneously controls the gains of the first harmonic signal and the first percussion signal in order to prevent mismatch of an extent capable of being recognized between signals as a gain difference of both channels is increased. That is, the apparatus 200 for processing an audio signal inputs the first harmonic signal and the first percussion signal to different channels so that respective channels can independently adjust the gains, and control gains of both channels using a common control module. Upon use of the common control module, the apparatus 200 for processing an audio signal adjusts the gains so that the second harmonic signal matches with the second percussion signal.

After separating the harmonic signal and the percussion signal, the apparatus 200 for processing an audio signal of the present disclosure individually adjusts parameters such as a time constant as well as the gains of respective signals. Upon adjusting the time constant, formats of respective signals can be changed. For example, when increasing the time constant, the signal becomes gentle. When reducing the time constant, the signal changes to a sharp format.

As described above, if the gains or time constants of the first harmonic signal and the first percussion signal are adjusted, the apparatus 200 for processing an audio signal adds the second harmonic signal and the second percussion signal to output an addition result (block 900). Using the foregoing scheme, the harmonic signal and the percussion signal are separated from the audio signal, gains of the harmonic signal and the percussion signal are individually adjusted, and the adjusted gains of the harmonic signal and the percussion signal are added to each other, and the addition result is output, so that a total volume of an output signal can be increased without non-linear distortion of some signals.

As described above, the present disclosure can generally improve apparatuses for controlling a gain and adopt a reproducing volume level to a current environment by separating the audio signal into a harmonic signal and a percussion signal to adjust a gain.

The present disclosure further provides an audio signal having a high output level without non-linear distortion and improve excitation performance of an embedded speaker.

Although the present disclosure has been described with an exemplary embodiment, various changes and modifications may be suggested to one skilled in the art. It is intended that the present disclosure encompass such changes and modifications as fall within the scope of the appended claims.

## Claims

1. A method of processing an audio signal, the method comprising:
separating (210) the audio signal into a first harmonic signal and a first percussion signal;
generating a second harmonic signal by adjusting a gain (230) of the first harmonic signal and a second percussion signal by adjusting a gain (250) of the first percussion signal;
and
adding (270) the second harmonic signal and the second percussion signal,
wherein a difference (290) between the gain of the first harmonic signal and the gain of the first percussion signal is less than or equal to a preset value.

2. The method of claim 1, wherein the separating of the audio signal into the first harmonic signal and the first percussion signal comprises:
generating a spectrogram associated with the audio signal by converting the audio signal into a time frequency domain;
acquiring a harmonic spectrogram and a percussion spectrogram using the spectrogram associated with the audio signal; and
converting the harmonic spectrogram into the first harmonic signal and the percussion spectrogram into the first percussion signal.

3. The method of claim 2, wherein the generating of the harmonic spectrogram comprises:
slicing the spectrogram associated with each preset frequency to generate at least two frequency frames;
performing a median filtering with respect to the at least two frequency frames; and
combining the at least two filtered frequency frames with each other to generate the harmonic spectrogram.

4. The method of claim 2, wherein generating of the percussion spectrogram comprises:
slicing the spectrogram associated with each preset time to generate at least two time frames;
performing a median filtering with respect to the at least two time frames; and
combining the at least two filtered time frames with each other to generate the percussion spectrogram.

5. The method of claim 1, wherein
the second harmonic signal does not exceed a first threshold, and
the second percussion signal does not exceed a second threshold.

6. An apparatus for processing an audio signal, the apparatus comprising:
a harmonic/percussion separator (210) configured to separate the audio signal into a first harmonic signal and a first percussion signal;
a first dynamic range controller, DRC, (230) configured to adjust a gain of the first harmonic signal to generate a second harmonic signal;
a second DRC (250) configured to adjust a gain of the first percussion signal to generate a second percussion signal;
an adder (270) configured to add the second harmonic signal and the second percussion signal; and
a gain controller (290) configured to control a difference between the gain of the first harmonic signal and the gain of the first percussion signal to be less than or equal to a preset value.

7. The apparatus of claim 6, wherein the harmonic/percussion separator comprises:
a spectrogram generator configured to convert the audio signal into a time frequency domain and to generate a spectrogram associated with the audio signal;
a spectrogram separator configured to generate a harmonic spectrogram and a percussion spectrogram using the spectrogram associated with the audio signal; and
a converter configured to convert the harmonic spectrogram into the first harmonic signal and the percussion spectrogram into the first percussion signal.

8. The apparatus of claim 7, wherein the spectrogram separator comprises a harmonic spectrogram generator configured to:
generate at least two frequency frames by slicing the spectrogram associated with each preset frequency;
perform a median filtering with respect to the at least two frequency frames; and
generate the harmonic spectrogram by combining the at least two filtered frequency frames with each other.

9. The apparatus of claim 7, wherein the spectrogram separator comprises a percussion spectrogram generator configured to:
generate at least two time frames by slicing the spectrogram associated with each preset time;
perform a median filtering with respect to the at least two time frames; and
generate the percussion spectrogram by combining the at least two filtered time frames with each other.

10. The apparatus of claim 6, wherein
the second harmonic signal does not exceed a first threshold; and
the second percussion signal does not exceed a second threshold.

11. The apparatus of claim 6, wherein the gain controller is further configured to control the gains of the first DRC and to control the gains of the second DRC at the same time.

12. The apparatus of claim 6, wherein the gain of the first harmonic signal differs from the gain of the first percussion signal.

13. The apparatus of claim 6, wherein the first DRC and the second DRC are configured with different parameters including a time constant and a gain.

## Patentansprüche

1. Verfahren zum Verarbeiten eines Audiosignals, wobei das Verfahren Folgendes umfasst: Trennen (210) des Audiosignals in ein erstes harmonisches Signal und ein erstes Perkussionssignal;
Erzeugen eines zweiten harmonischen Signals durch Einstellen einer Verstärkung (230) des ersten harmonischen Signals und eines zweiten Perkussionssignals durch Einstellen einer Verstärkung (250) des ersten Perkussionssignals; und
Addieren (270) des zweiten harmonischen Signals und des zweiten Perkussionssignals, wobei eine Differenz (290) zwischen der Verstärkung des ersten harmonischen Signals und der Verstärkung des ersten Perkussionssignals kleiner oder gleich einem voreingestellten Wert ist.

2. Verfahren nach Anspruch 1, wobei die Trennung des Audiosignals in das erste harmonische Signal und das erste Perkussionssignal Folgendes umfasst:
Erzeugen eines Spektrogramms, das dem Audiosignal zugeordnet ist, durch Umwandeln des Audiosignals in einen Zeitfrequenzbereich;
Erfassen eines harmonischen Spektrogramms und eines Perkussionsspektrogramms unter Verwendung des Spektrogramms, das dem Audiosignal zugeordnet ist; und
Umwandeln des harmonischen Spektrogramms in das erste harmonische Signal und des Perkussionsspektrogramms in das erste Perkussionssignal.

3. Verfahren nach Anspruch 2, wobei die Erzeugung des harmonischen Spektrogramms Folgendes umfasst:
Aufteilen des Spektrogramms, das jeder voreingestellten Frequenz zugeordnet ist, um mindestens zwei Frequenzrahmen zu erzeugen;
Durchführen einer Medianfilterung in Bezug auf die mindestens zwei Frequenzrahmen; und
Kombinieren der mindestens zwei gefilterten Frequenzrahmen miteinander, um das harmonische Spektrogramm zu erzeugen.

4. Verfahren nach Anspruch 2, wobei die Erzeugung des Perkussionsspektrogramms Folgendes umfasst:
Aufteilen des Spektrogramms, das jeder voreingestellten Zeit zugeordnet ist, um mindestens zwei Zeitrahmen zu erzeugen;
Durchführen einer Medianfilterung in Bezug auf die mindestens zwei Zeitrahmen; und
Kombinieren der mindestens zwei gefilterten Zeitrahmen miteinander, um das Perkussionsspektrogramm zu erzeugen.

5. Verfahren nach Anspruch 1, wobei
das zweite harmonische Signal einen ersten Schwellenwert nicht überschreitet und
das zweite Perkussionssignal einen zweiten Schwellenwert nicht überschreitet.

6. Vorrichtung zur Verarbeitung eines Audiosignals, wobei die Vorrichtung Folgendes umfasst:
einen harmonischen/Perkussions-Separator (210), der dafür konfiguriert ist, das Audiosignal in ein erstes harmonisches Signal und ein erstes Perkussionssignal zu trennen;
einen ersten Dynamikbereichregler (Dynamic Range Controller, DRC) (230), der dafür konfiguriert ist, eine Verstärkung des ersten harmonischen Signals einzustellen, um ein zweites harmonisches Signal zu erzeugen;
einen zweiten DRC (250), der dafür konfiguriert ist, eine Verstärkung des ersten Perkussionssignals einzustellen, um ein zweites Perkussionssignal zu erzeugen;
einen Addierer (270), der dafür konfiguriert ist, das zweite harmonische Signal und das zweite Perkussionssignal zu addieren; und
einen Verstärkungsregler (290), der dafür konfiguriert ist, eine Differenz zwischen der Verstärkung des ersten harmonischen Signals und der Verstärkung des ersten Perkussionssignals zu steuern, so dass sie kleiner oder gleich einem voreingestellten Wert ist.

7. Vorrichtung nach Anspruch 6, wobei der harmonische/Perkussions-Separator Folgendes umfasst:
einen Spektrogrammgenerator, der dafür konfiguriert ist, das Audiosignal in einen Zeitfrequenzbereich umzuwandeln und ein Spektrogramm zu erzeugen, das dem Audiosignal zugeordnet ist;
einen Spektrogrammseparator, der dafür konfiguriert ist, ein harmonisches Spektrogramm und ein Perkussionsspektrogramm unter Verwendung des Spektrogramms, das dem Audiosignal zugeordnet ist, zu erzeugen; und
einen Wandler, der dafür konfiguriert ist, das harmonische Spektrogramm in das erste harmonische Signal und das Perkussionsspektrogramm in das erste Perkussionssignal umzuwandeln.

8. Vorrichtung nach Anspruch 7, wobei der Spektrogrammseparator einen harmonischen Spektrogrammgenerator umfasst, der für Folgendes konfiguriert ist:
Erzeugen von mindestens zwei Frequenzrahmen durch Aufteilen des Spektrogramms, das jeder voreingestellten Frequenz zugeordnet ist;
Durchführen einer Medianfilterung in Bezug auf die mindestens zwei Frequenzrahmen; und
Erzeugen des harmonischen Spektrogramms durch Kombinieren der mindestens zwei gefilterten Frequenzrahmen miteinander.

9. Vorrichtung nach Anspruch 7, wobei der Spektrogrammseparator einen Perkussionsspektrogrammgenerator umfasst, der für Folgendes konfiguriert ist:
Erzeugen von mindestens zwei Zeitrahmen durch Aufteilen des Spektrogramms, das jeder voreingestellten Zeit zugeordnet ist;
Durchführen einer Medianfilterung in Bezug auf die mindestens zwei Zeitrahmen; und
Erzeugen des Perkussionsspektrogramms durch Kombinieren der mindestens zwei gefilterten Zeitrahmen miteinander.

10. Vorrichtung nach Anspruch 6, wobei
das zweite harmonische Signal einen ersten Schwellenwert nicht überschreitet und
das zweite Perkussionssignal einen zweiten Schwellenwert nicht überschreitet.

11. Vorrichtung nach Anspruch 6, wobei der Verstärkungsregler ferner dafür konfiguriert ist, die Verstärkungen des ersten DRC zu steuern und gleichzeitig die Verstärkungen des zweiten DRC zu steuern.

12. Vorrichtung nach Anspruch 6, wobei sich die Verstärkung des ersten harmonischen Signals von der Verstärkung des ersten Perkussionssignals unterscheidet.

13. Vorrichtung nach Anspruch 6, wobei der erste DRC und der zweite DRC mit unterschiedlichen Parametern einschließlich einer Zeitkonstante und einer Verstärkung konfiguriert sind.

## Revendications

1. Un procédé de traitement d'un signal audio, le procédé comprenant : la séparation (210) du signal audio en un premier signal d'harmoniques et un premier signal de percussion,
la génération d'un deuxième signal d'harmoniques par l'ajustement d'un gain (230) du premier signal d'harmoniques et d'un deuxième signal de percussion par l'ajustement d'un gain (250) du premier signal de percussion, et
l'addition (270) du deuxième signal d'harmoniques et du deuxième signal de percussion, où une différence (290) entre le gain du premier signal d'harmoniques et le gain du premier signal de percussion est inférieure ou égale à une valeur prédéfinie.

2. Le procédé selon la Revendication 1, où la séparation du signal audio en le premier signal d'harmoniques et le premier signal de percussion comprend :
la génération d'un spectrogramme associé au signal audio par la conversion du signal audio en un domaine temps-fréquence,
l'acquisition d'un spectrogramme d'harmoniques et d'un spectrogramme de percussion au moyen du spectrogramme associé au signal audio, et
la conversion du spectrogramme d'harmoniques en le premier signal d'harmoniques et le spectrogramme de percussion en le premier signal de percussion.

3. Le procédé selon la Revendication 2, où la génération du spectrogramme d'harmoniques comprend :
la division du spectrogramme associé à chaque fréquence prédéfinie de façon à générer au moins deux trames de fréquence,
l'exécution d'un filtrage médian par rapport aux au moins deux trames de fréquence, et
la combinaison des au moins deux trames de fréquence filtrées l'une avec l'autre de façon à générer le spectrogramme d'harmoniques.

4. Le procédé selon la Revendication 2, où la génération du spectrogramme de percussion comprend :
la division du spectrogramme associé à chaque instant prédéfini de façon à générer au moins deux trames temporelles,
l'exécution d'un filtrage médian par rapport aux au moins deux trames temporelles, et
la combinaison des au moins deux trames temporelles filtrées l'une avec l'autre de façon à générer le spectrogramme de percussion.

5. Le procédé selon la Revendication 1, où
le deuxième signal d'harmoniques ne dépasse pas un premier seuil, et
le deuxième signal de percussion ne dépasse pas un deuxième seuil.

6. Un appareil de traitement d'un signal audio, l'appareil comprenant :
un séparateur harmonique/percussion (210) configuré de façon à séparer le signal audio en un premier signal d'harmoniques et un premier signal de percussion,
un premier dispositif de commande de gamme dynamique, DRC, (230) configuré de façon à ajuster un gain du premier signal d'harmoniques de façon à générer un deuxième signal d'harmoniques,
un deuxième DRC (250) configuré de façon à ajuster un gain du premier signal de percussion de façon à générer un deuxième signal de percussion,
un sommateur (270) configuré de façon à additionner le deuxième signal d'harmoniques et le deuxième signal de percussion, et
un dispositif de commande de gain (290) configuré de façon à commander une différence entre le gain du premier signal d'harmoniques et le gain du premier signal de percussion de façon à être inférieure ou égale à une valeur prédéfinie.

7. L'appareil selon la Revendication 6, où le séparateur harmonique/percussion comprend :
un générateur de spectrogramme configuré de façon à convertir le signal audio en un domaine temps-fréquence et à générer un spectrogramme associé au signal audio,
un séparateur de spectrogramme configuré de façon à générer un spectrogramme d'harmoniques et un spectrogramme de percussion au moyen du spectrogramme associé au signal audio, et
un convertisseur configuré de façon à convertir le spectrogramme d'harmoniques en le premier signal d'harmoniques et le spectrogramme de percussion en le premier signal de percussion.

8. L'appareil selon la Revendication 7, où le séparateur de spectrogramme comprend un générateur de spectrogramme d'harmoniques configuré de façon à :
générer au moins deux trames de fréquence par la division du spectrogramme associé à chaque fréquence prédéfinie,
exécuter un filtrage médian par rapport aux au moins deux trames de fréquence, et
générer le spectrogramme d'harmoniques par la combinaison des au moins deux trames de fréquence filtrées l'une avec l'autre.

9. L'appareil selon la Revendication 7, où le séparateur de spectrogramme comprend un générateur de spectrogramme de percussion configuré de façon à :
générer au moins deux trames temporelles par la division du spectrogramme associé à chaque instant prédéfini,
exécuter un filtrage médian par rapport aux au moins deux trames temporelles, et
générer le spectrogramme de percussion par la combinaison des au moins deux trames temporelles filtrées l'une avec l'autre.

10. L'appareil selon la Revendication 6, où
le deuxième signal d'harmoniques ne dépasse pas un premier seuil, et
le deuxième signal de percussion ne dépasse pas un deuxième seuil.

11. L'appareil selon la Revendication 6, où le dispositif de commande de gain est configuré en outre de façon à commander les gains du premier DRC et les gains du deuxième DRC simultanément.

12. L'appareil selon la Revendication 6, où le gain du premier signal d'harmoniques diffère du gain du premier signal de percussion.

13. L'appareil selon la Revendication 6, où le premier DRC et le deuxième DRC sont configurés avec des paramètres différents comprenant une constante de temps et un gain.
